(19) Europäisches Patentamt
European Patent Office
Office européen des brevets

(11) **EP 2 696 383 A1**

(12) **EUROPEAN PATENT APPLICATION**

(43) Date of publication:
**12.02.2014 Bulletin 2014/07**

(51) Int Cl.:
***H01L 51/00*** *(2006.01)* ***H01L 51/50*** *(2006.01)*

(21) Application number: **12005808.6**

(22) Date of filing: **10.08.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **SOLVAY SA**
**1120 Bruxelles (BE)**

(72) Inventors:
- **Caille, Jean-Raphael**
  **5000 Namur (BE)**
- **Maunoury, Jonathan**
  **1030 Bruxelles (BE)**

(74) Representative: **Metten, Karl-Heinz**
**Boehmert & Boehmert**
**Pettenkoferstrasse 20-22**
**80336 München (DE)**

(54) **Multilayered organic electronic devices**

(57) Multilayered organic electronic device wherein at least one non-electrode layer thereof before deposition of the subsequent layer has a low surface roughness and process for manufacturing such devices.

Figure 1. Structure of the OLED devices used in Examples 3a to 3d.

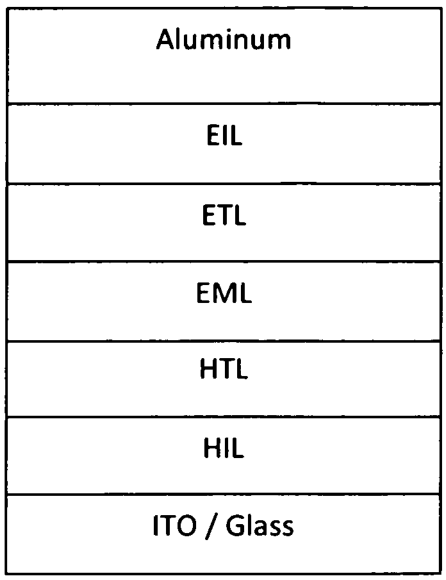


EP 2 696 383 A1

## Description

The present invention relates to multilayered organic electronic devices, in particular organic light emitting diodes wherein at least one non-electrode layer has a surface roughness not exceeding certain values.

Today, various display devices are under active study and development, in particular those based on electroluminescence (EL) from organic materials.

In contrast to photoluminescence, i.e. the light emission from an active material as a consequence of optical absorption and relaxation by radiative decay of an excited state, electroluminescence (EL) is a non-thermal generation of light resulting from the application of an electric field to a substrate. In this latter case, excitation is accomplished by recombination of charge carriers of contrary signs (electrons and holes) injected into an organic semiconductor in the presence of an external circuit.

A simple prototype of an organic light-emitting diode (OLED), i.e. a single layer OLED, is typically composed of a thin film of an active organic material which is sandwiched between two electrodes, one of which needs to have a degree of transparency sufficient in order to observe light emission from the organic layer.

If an external voltage is applied to the two electrodes, charge carriers, i.e. holes, at the anode and electrons at the cathode are injected to the organic layer beyond a specific threshold voltage depending on the organic material applied. In the presence of an electric field, charge carriers move through the active layer and are non-radiatively discharged when they reach the oppositely charged electrode. However, if a hole and an electron encounter one another while drifting through the organic layer, excited singlet (anti-symmetric) and triplet (symmetric) states, so-called excitons, are formed. Light is thus generated in the organic material from the decay of molecular excited states (or excitons). For every three triplet excitons that are formed by electrical excitation in an OLED, one anti-symmetric state (singlet) exciton is created.

Organic electronic devices typically comprise one or more semiconductive layers between electrodes.

For a number of reasons multilayer devices have been found to be advantageous especially in the field of Organic Light Emitting Diodes (OLEDs) as this allows optimizing the performance and the efficiency of the device.

High efficiency OLEDs based on small molecules usually comprise a multiplicity of different layers, each layer being optimized towards achieving the optimum efficiency of the overall device.

Typically such OLEDs comprise at least five layers: a p-doped transport layer (also referred to as hole injection layer or HIL), an usually undoped hole transport layer (HTL) also referred to as an electron blocking layer, at least one emissive layer (EML), an usually undoped electron transport layer (ETL) also referred to as an hole blocking layer, and a doped electron injection layer (EIL). This kind of devices is generally known as pi-n OLED and has the generic structure described in Figure 1.

The multiple layers are normally prepared sequentially by depositing subsequent layers onto the layers produced in a preceding step. One challenge in this regard, especially in solution based processes is to avoid the interfacial mixing between the different layers as this might have a detrimental influence on the performance of the device. In solution based processes the difficulty arises that the matrix materials used in the different layers are often more or less soluble in organic solvents and thus deposition of a subsequent layer out of solution, i.e. with a solvent, may lead to undesired changes in the structure of the previous layer.

In order to achieve an optimum efficiency, the physical properties of each material for each individual layer of the stack (as e.g. carrier transport properties, HOMO and LUMO levels, triplet levels) have to be optimised depending on the functionality of the layer.

Another issue of paramount importance is to optimize the performance property of a device for a given material combination in the layers, especially in terms of lifetime and efficiency of the device.

Significant research efforts have been made to select optimum materials for the different layers of a multilayer OLED device in order to improve the performance and lifetime of the devices.

The influence of the smoothness of the electrode materials in organic light emitting devices has been investigated by Lee et al., Thin Solid Films 411 (2002), 11-16. They show that reducing the surface roughness of the ITO electrode commonly used in such devices can be advantageous for the perfomance properties of the device.

Gruner et al. ACS nano, Vol. 3 No. 8, 2258-2264 (2009) describe the surface modification of nanotube anodes for high performance organic light emitting diodes.

Yokoyama et al., J. Electrochem. Soc., 154, J159-J162 (2007) shows the effects of post-fabrication thermal annealing on performance of organic light emitting diodes.

There still exists a need however to improve performance and lifetime of organic light emitting diodes.

Accordingly, it was an object of the present invention to provide organic electronic devices, in particular organic light emitting diodes with an improved combination of performance and lifetime.

This object has been achieved with multilayered organic electronic devices wherein at least one non-electrode layer thereof before deposition of the subsequent layer has a surface roughness RMS value of 3.5 nm or less, preferably 3 nm or less and particularly preferably of 2 nm or less measured by atomic force microscopy with a probe tip diameter

of 7 nm and a scanned surface area of 5x5 $\mu m^2$.

The term non-electrode layer for the purpose of the present invention is intended to designate a layer of the organic electronic device other than cathode or anode thereof.

The surface roughness RMS when used in the context of this invention is defined as the root mean squared roughness calculated in accordance with the formula $RMS = \sqrt{(h_1^2 + h_2^2 + \ldots + h_n^2)/n}$ wherein each $h_n$ represents the individual ordinate (vertical height or depth) of a measurement point n relative to the centre plane which is determined by equating the volumes enclosed by the image of the surface above and below the plane. Accordingly, from a mathematical perspective, the RMS roughness represents the standard deviation of the individual heights of the measurement points for the sample area examined.

Atomic Force Microscopy (often referred to as AFM) is a form of scanning probe microscopy where a small probe is scanned across the surface of the sample to obtain information on the surface of the sample. The sample is scanned in a raster pattern across the sample to form a map of the surface relative to the x-y-position. Accordingly, AFM shows the variation in the height over the area imaged and is a suitable tool to determine the surface properties.

The present invention is based on the finding that the efficiency and lifetime of organic electronic devices can be improved by controlling respectively modifying the surface roughness of the non-electrode layers of the device prior to the deposition of the respective subsequent layer. To achieve beneficial results it is sufficient if one of the non-electrode layers, prior to the deposition of the subsequent layer has a high smoothness as expressed through the RMS value defined in claim 1; in accordance with a preferred embodiment of the present invention, however, more than one non-electrode layer and even more preferably substantially all and most preferably all the non-electrode layers of the device have a surface roughness as defined in claim 1 before deposition of the respective subsequent layer.

In accordance with another preferred embodiment the maximum height of a measurement point relative to the centre plane, sometimes also referred to as z-range or peak-to-valley amplitude (as defined above) in the area examined is 30 nm or less, preferably 25 nm or less and even more preferably less than 20 nm

The beneficial effect of the present invention in multilayered organic devices is independent of the chemical structure of the materials on which the various non-electrode layers are based. Accordingly, it is not necessary to describe the specific composition of the respective non-electrode layers in great detail here as the skilled person can chose any material for any non-electrode layer provided the surface roughness is controlled and adjusted to be within the range claimed. Suitable materials for the various non-electrode layers of multi-layered devices are described in the literature and respective products are commercially available to a certain degree.

The multilayered devices in accordance with the present invention may be obtained by any of the processes described in the prior art and known to the skilled person. Just by way of example reference may be made here to vapor deposition techniques according to which the various layers are deposited consecutively from the gaseous phase. Solution processing techniques may also be applied and the skilled person will select the appropriate manufacturing process based on the individual circumstances and the individual material for the various layers. Combinations of vapor deposition and solution based processes are also possible where a part of the layers is formed by vapor deposition whereas another part is deposited from solution.

In certain cases solution processing for the manufacture of one or more layers has proved to be advantageous.

Layers deposited by a solution based process in some cases have a higher surface roughness than layers prepared by vapour deposition techniques. Accordingly, the control of the surface roughness RMS by virtue of the present invention and in accordance with the process of the present invention may provide particularly beneficial results for layers which are deposited by solution-based technologies and organic electronic devices based on such layers.

Depending on the process of deposition of the various non-electrode layers, the surface roughness of the products obtained may vary. Accordingly, under optimum conditions, if the deposition process is selected carefully, a comparatively low surface roughness may already be obtained immediately after the deposition without any further treatment. The combination of the deposition conditions combined with the selection of the best material for the respective layer to be deposited is the first step to achieve an improvement in surface roughness. Under ideal circumstances the surface roughness of the film may already be within the required range without further treatment after deposition. The temperature conditions during the deposition may also have an influence on the surface roughness of the layer obtained as well as the speed of deposition.

Usually, however, it is advantageous or sometimes necessary to apply a suitable treatment to the layer deposited to bring the surface roughness to the desired range as defined in claim 1.

Methods for the modification of the surface properties and in particular the surface roughness of films are known to the skilled person and only by way of example chemical etching, irradiation (e.g. UV irradiation) or thermal annealing are mentioned here.

Chemical etching may be used to remove spikes and other protrusions from the surface of a film and thereby a reduction of the surface roughness of the respective film may also be obtained.

Irradiation, e.g. UV irradiation may also be useful to modify the surface roughness of a film by chemical modification of the molecule structure. This may bear the risk, however, that the performance of the devices may be detrimentally affected if the chemical structure of the material forming the layer is modified.

Accordingly, methods capable of achieving a reduction in surface roughness but at the same time avoiding as much as possible the probability of a change in the chemical structure of the materials are generally preferable.

In the course of the invention it has been found that thermal annealing after deposition is an effective means for reducing the surface roughness to achieve the required smoothness as defined in claim 1. Accordingly, if the surface roughness directly after deposition is exceeding the RMS values defined in claim 1, a thermal annealing treatment can be preferably used to reduce the RMS values to the level as required in claim 1.

Thermal annealing, unless the annealing temperature is too high, does not normally change the composition of the layer but only the morphological structure and thereby the surface roughness.

Annealing temperatures are chosen below the point where a decomposition of the non-electrode layer materials may be expected. In general annealing temperatures of from 70 to 200 °C, preferably of from 80 to 180 °C and even more preferably in the range of from 100 to 170 °C have proven to be effective.

The ideal annealing temperature thus depends on the material of the layer. Temperatures suitable for one material might be too high for another material. The skilled person will decide based on his knowledge of the properties of the materials of the layer in the specific case which temperatures and durations for thermal annealing should be used.

The time period of annealing is usually in the range of from 2 minutes to 180 minutes, preferably of from 3 minutes to 120 minutes and even more preferably of from 5 to 90 minutes. In certain cases annealing times of twenty minutes or more may be advantageous. It is not normally desirable or necessary to conduct the thermal annealing for more than 180 minutes, more preferably for more than 120 minutes.

It is apparent that there is a relationship between annealing temperature and annealing time. Comparable effects on reduction of surface roughness might be obtained in shorter times at higher annealing temperatures generally; it has of course to be taken into account that certain materials are limited to certain maximum annealing temperatures, which might then require an increase in annealing time as the temperature is limited. Obviously, for economic reasons it is desirable to shorten the annealing time as far as possible without negatively influencing the surface roughness.

It is possible to use a temperature gradient for the annealing treatment but the annealing treatment can also be effectively carried out at a constant temperature.

The skilled person is aware of further additional techniques which are known to be effective for reducing the roughness of surfaces and he will chose the suitable technique, if necessary, to adjust the surface roughness of a deposited layer to achieve the desired smoothness in accordance with claim 1 and the dependent claims.

Preferred organic electronic devices in accordance with the present invention are organic electronic diodes as e.g. used in photovoltaic cells or the like and organic light emitting diodes, commonly referred to as OLED.

By controlling and adjusting the surface roughness properties of the non-electrode layers prior to deposition of the respective subsequent layers, the lifetime and performance of the devices can be improved compared to products with surface roughness properties outside the scope of claim 1.

Depending on the conditions of the deposition of the layers deposited on the non-electrode layer for which the surface roughness has been adjusted in accordance with the present invention, the final device may still reflect the surface roughness of said adjusted layer; it might, however, also be possible that as a result of the deposition of subsequent layers a certain modification of the surface roughness might have occurred. Accordingly it is preferable, but not necessary that the final device still reflects the surface roughness of the non-electrode layers for which same has been adjusted in accordance with the present invention.

The surface roughness of single layers in the final multilayered device might not be easy to determine. This is not necessary, however, as the essential requirement is that the surface roughness is determined and, if necessary, adjusted, for at least one non-electrode layer of the device prior to the deposition of the subsequent layer. A subsequent modification after deposition of the subsequent layer should not be detrimental unless the continuity of the layer would be disrupted, which would, however, be fatal for the performance of the device anyhow. Thus, it is not necessary to invest time and resources to determine the morphology of the individual layers of the final device.

In some cases it might be advantageous to subject the final device to a post-fabrication annealing treatment as disclosed in Yokoyama et al. J. Electrochem. Soc., 154 J159-J162 (2007) which has been cited hereinbefore. Such a treatment is not necessary, however.

Another aspect of the present invention relates to a process for the manufacture of multi-layered organic electronic devices comprising at least one non-electrode layer by consecutive deposition of layers wherein for at least one non-electrode layer prior to depositing the subsequent layer, the surface roughness RMS is determined by atomic force microscopy with a probe tip diameter of 7 nm and a scanned surface area of 5x5 $\mu m^2$, and, if the surface roughness thus determined exceeds 3.5 nm, the surface roughness of said non-electrode layer is reduced to 3.5 nm or less, preferably to 3.0 nm or less, even more preferably to less than 2.5 nm and most preferably to 2 nm or less, prior to the deposition of the subsequent layer.

Further preferred embodiments of the process in accordance with the present invention may be taken from the previous description concerning the devices in accordance with the present invention to which reference is made herewith.

The devices in accordance with the present invention can advantageously be used where long lifetimes and good efficiency are key properties.

The following examples show the benefits of the present invention.

Atomic force microscopy measurements

The images were acquired at room temperature in air with a Dimension 3100 microscope (Digital Instruments, Bruker) with a Nanoscope IIIa controller, operated in intermittent contact (Tapping mode) with phase imaging. Roughness calculations were performed on the flattened images. Data were processed with a Nanoscope 5.30r3.sr3 software. For each image, the mean roughness (Ra), the RMS (or Rq) roughness and the z range (peak-to-valley difference in height values) were calculated. Mean roughness (Ra) is defined as the arithmetic average of the absolute values of the surface height deviations measured from the mean plane. RMS is the standard deviation of the surface height deviations measured from the mean plane.

Testing conditions

Scan area: 5x5 $\mu m^2$

Scan rate: 1 Hz

Pixel density: 512 x 512

Probe: OTESPA silicon tip from Bruker (12-103 Nm-1 force constant and 275-334 kHz resonance frequency). Nominative tip radius of 7 nm. Maximum tip radius of 10 nm.
Further details available at:

http://www.brukerafmprobes.com/Product.aspx?ProductID=3381

Number of scanned areas : one, randomly chosen

Scan angle: 0°

Data processing: 1 st order flattening of the whole image

Example 1 - Preparation of N,N'-di-1-naphthyl-N,N'-(4-t-butyl-phenyl)-1,1'-biphenyl-4,4'diamine (hereinafter referred to as Compound A)

The synthesis of Compound A was carried out by the use of an intermediate which had been prepared via a Buchwald-Hartwig reaction between naphtylamine and dibromo biphenyl. The reaction was conducted at 80°C using $Pd(dba)_2$ as the catalyst and tri-tert-butylphosphine as the ligand according to the scheme below

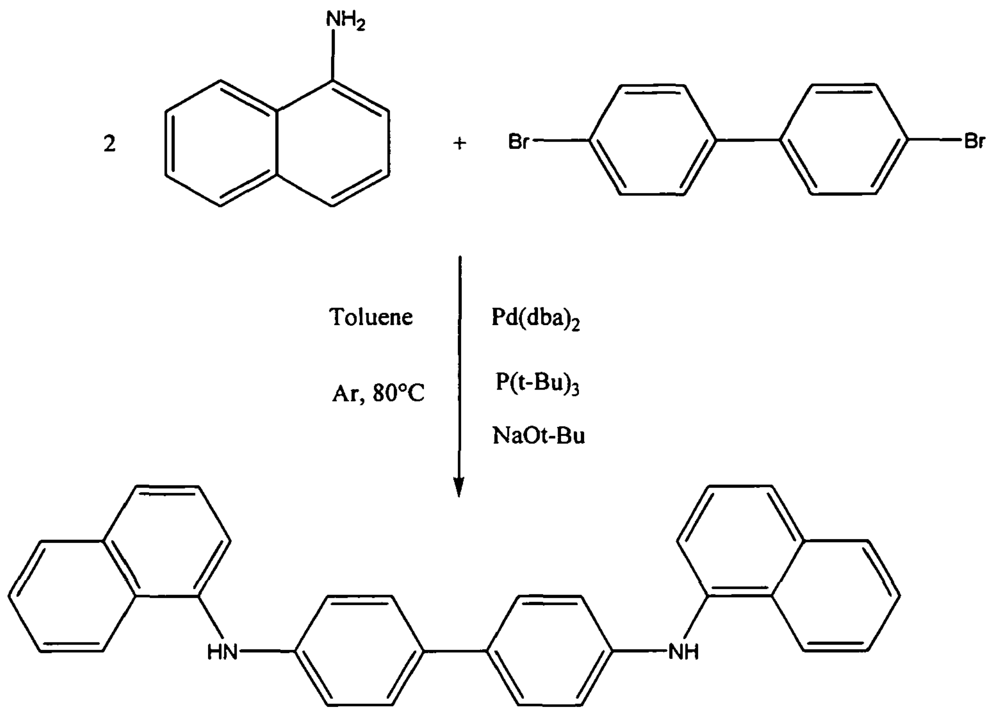


The conversion of starting materials to give N4,N4'-di(naphthalen-1-yl)biphenyl-4,4'-diamine) was very high according to HPLC results. Recovery and purification steps induced some loss and overall yield was comprised between

60 and 70%.

A Buchwald-Hartwig reaction has been used to prepare Compound A as described in the following scheme. Using the couple catalyst-ligand represented in this scheme the desired product was obtained in high yield

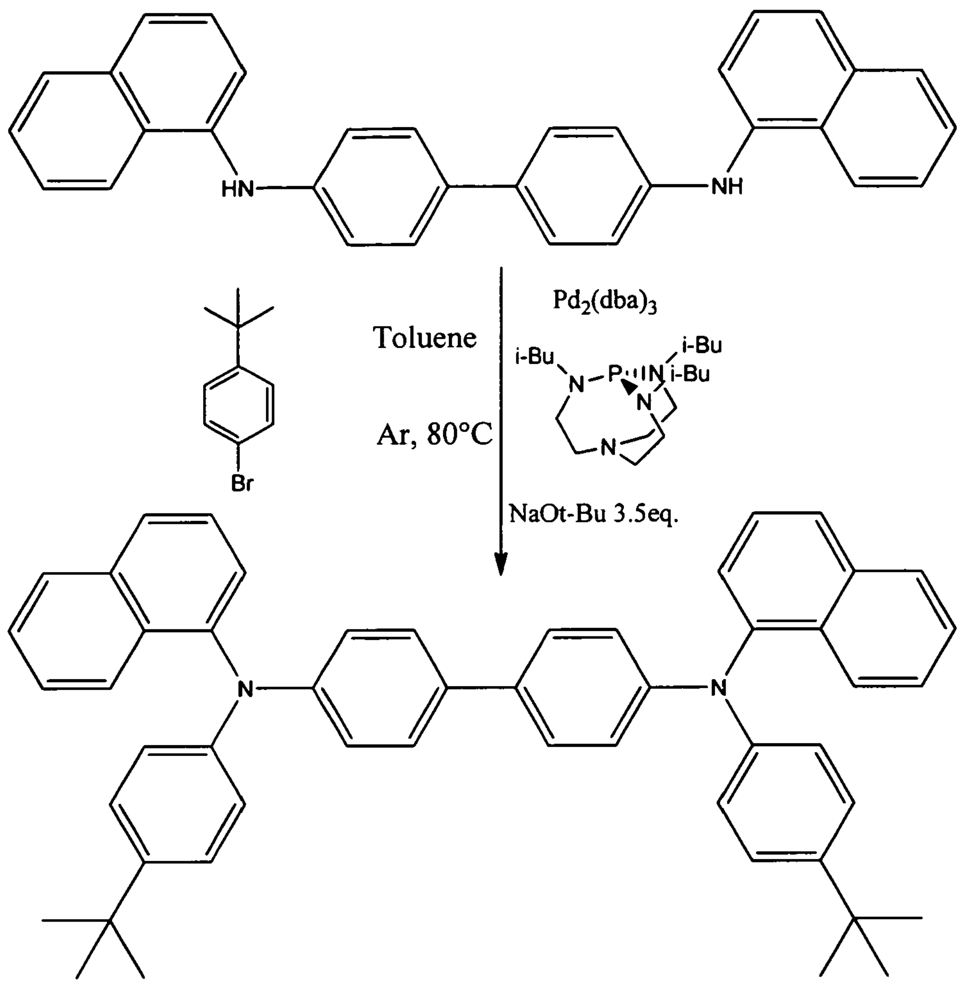


Example 2 - Preparation of N,N'-di-1-naphthyl-N,N'-(4-cyclohexyl-phenyl)-1,1'-biphenyl-4,4'diamine (hereinafter referred to Compound B).

Compound B was obtained in a similar way as Compound A except that 1-bromo-4-cyclohexylbenzene was used as a starting material to replace 1-bromo-4-tert-butylbenzene.

General method for device manufacture

All device examples were fabricated by a combination of high vacuum thermal evaporation and solution process (spin-coating). The anode electrode was 120 nm of indium tin oxide (ITO). All devices were encapsulated with a glass lid sealed with an epoxy resin in a nitrogen glove box (<1 ppm of $H_2O$ and $O_2$) immediately after fabrication, and a moisture getter was incorporated inside the package. The devices were characterized optically and electrically with a C9920-12 External Quantum Efficiency Measurement System from HAMAMATSU. EQE refers to external quantum efficiency expressed in %, while operational stability tests were done by driving the devices at continuous current at room temperature. $LT_{85}$ and $LT_{80}$ are measures of lifetime and correspond to the time for light output to decrease to respectively 85% and 80% of the initial value, when the device is driven at a constant current.

The OLED stack consisted of sequentially, from the ITO surface, 60 nm of Plexcore OC (a self-doping polymer, poly(thiophene-3-[2[(2-methoxyethoxy)ethoxy]-2,5-diyl), supplied from Plextronics Inc.)

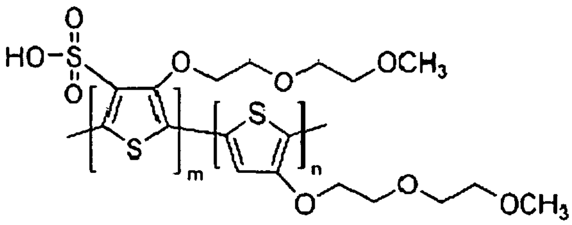

deposited by spin-coating in air. Further fabrication step were carried out in a nitrogen glove box (<1 ppm of H2O and O2). The HIL is annealed on a hot plate at 200 °C for 20 min. On top of the HIL, a hole transport layer (HTL) of 20 nm was deposited by spin-coating from a a 0.5 wt% solution of Compound A or Compound B in toluene. The HTL was then annealed on a hot plate at various temperatures for 30 min.

Then a 20nm layer of TCzMe doped with 20% of tris(2-phenylquinoline)iridium(III) [Ir(2-phq)$_3$] was deposited by vacuum-thermal evaporation as the emissive layer (EML). Then a 10nm layer of bis(2-methyl-8-quinolinolate)-4-(phenylphenolato)aluminium (BAlq) was deposited by vacuum-thermal evaporation as the electron transport layer (ETL). Then, a 45 nm layer of BPhen:$Cs_2CO_3$10% (BPhen = 4,7-Diphenyl-1,10-phenanthroline) was deposited by vacuum-thermal evaporation as the electron injection layer (EIL). The cathode consisted of 100 nm of Al.

As used herein, Compound A, Compound B, TCzMe, Ir(phq)$_3$, BAlq and BPhen have the following structures:

Compound A

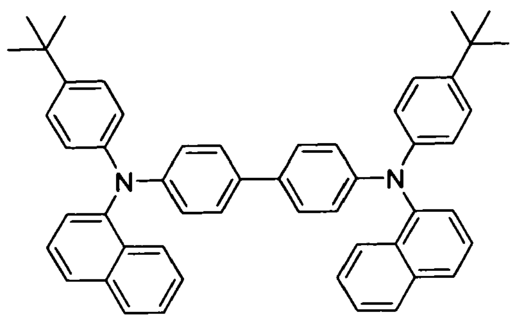

Compound B

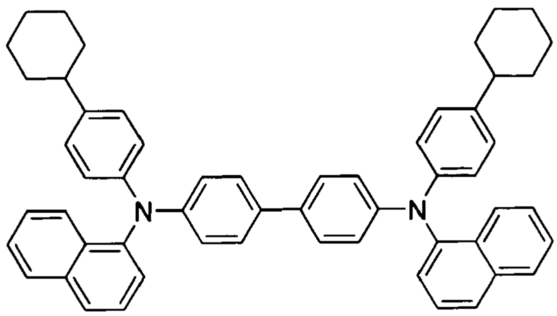

TCzMe

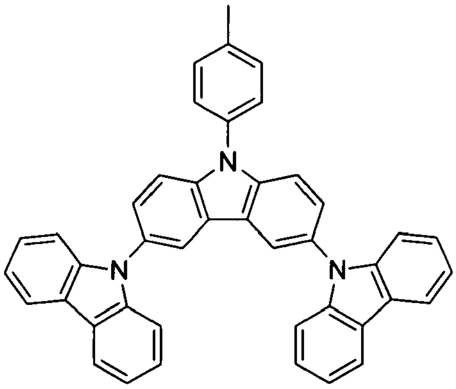

Ir(2-phq)$_3$

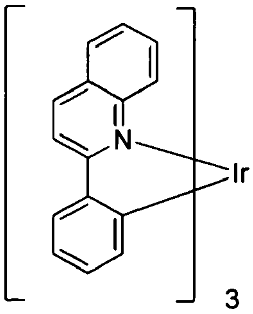

Balq

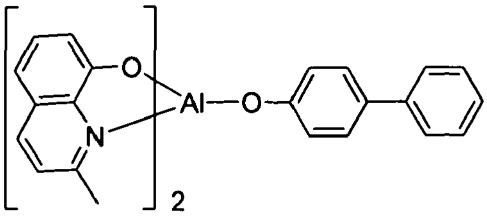

BPhen

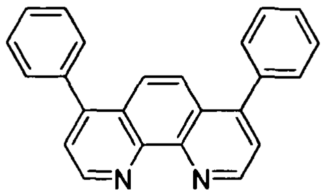

As described above, the HTL films based on Compound A or Compound B was subjected to thermal annealing for 30 min on a hot plate. Different temperatures were used and the HTL surface was examined by AFM to assess the impact of surface morphology on device performance and lifetime.

Example 3 - Devices comprising a layer based on Compound A as hole transport layer.

Table 1 summarises the annealing conditions and the corresponding RMS values and the peak (maximum) height determined by AFM for HTL films based on Compound A

Table 1

| Ex. | Temperature | Duration | RMS (nm) | Max. height (nm) |
|---|---|---|---|---|
| 3a | 100 °C | 30 min | 2.2 | 18.1 |
| 3b | 120 °C | 30 min | 1.4 | 10.1 |
| 3c | 140 °C | 30 min | 1.2 | 7.8 |
| 3d | 160 °C | 30 min | 0.5 | 4.4 |

From table 1 it is clear that increasing the annealing temperature from 100 to 160 °C has a clear impact on the surface morphology as the RMS decreases from 2.2 to 0.5 nm and the maximum height decreases from 18.1 to 4.4 nm. For this given material, increasing the annealing temperature results in obtaining smoother film surface morphology

Table 2. Performance and lifetime for devices of Examples 3a to 3d based on Compound A

Table 2

| Example | EQE (%) at 1000 cd/m2 | LT 85 (h) ($L_0$= 2000 cd/$m^2$) |
|---|---|---|
| 3a | 6.1 | 138 |
| 3b | 6.2 | 368 |
| 3c | 5.9 | 432 |
| 3d | 6.1 | 260 |

LT 85 denotes the time after which the light intensity had decreased to 85 % of the initial value $L_0$. and EQE denotes the external quantum efficiency in %

The devices of Examples 3a to 3d showed a comparable EQE in the range of 6% indicating that the difference in HTL film morphology has no detrimental impact on the efficiency of the device.

Large differences were observed, however, for the lifetime ($LT_{85}$). The lowest lifetime is obtained for example 3a where the HTL has the highest roughness (RMS of 2.2 nm and maximum height of 18.1 nm). The $LT_{85}$ increases more than three times from 138 h (example 3a) up to 432h (example 3c) as the RMS and the maximum height are reduced to 1.2 nm and 7.8 nm respectively. The device of example 3d shows a drop in lifetime compared to example 3c despite having the smoother HTL film which is due to the fact that the annealing temperature was too high for the chosen duration of the annealing time.

Example 4: Devices including a HTL based on Compound B

Table 3 summarises the annealing conditions and the corresponding RMS values and the peak (maximum) height determined by AFM for HTL films based on Compound B.

Table 3. HTL based on Compound B

| Ex. | Temperature | Duration | RMS (nm) | Max. height (nm) |
|---|---|---|---|---|
| 4a | 120 °C | 5 min | 2.0 | 12.8 |
| 4b | 140 °C | 5 min | 1.8 | 12.9 |
| 4c | 160 °C | 5 min | 2.3 | 19.0 |
| 4d | 180 °C | 5 min | 1.7 | 12.0 |

From table 3 it is clear that increasing the annealing temperature from 120 to 180 °C has a limited impact on the surface morphology as all the RMS are in the range of 1.7-2.3 nm and all the maximum heights are in the range of 12-13 nm except for example 4c. This values show that smooth HTL films can be obtained with compound B irrespective of the annealing temperature. Without being bound to any theory this effect might be related to the presence of cyclohexyl substituent in Compound B which may support the formation of smooth films.

Table 4. Performance and lifetime for devices of Examples 4a to 4d based on Compound B

| Example | EQE (%) at 1000 cd/$m^2$ | LT 80 (h) ($L_0$= 2000 cd/$m^2$) |
|---|---|---|
| 4a | 6.9 | 412 |

(continued)

| Example | EQE (%) at 1000 cd/m$^2$ | LT 80 (h) ($L_0$= 2000 cd/m$^2$) |
|---|---|---|
| 4b | 6.9 | 436 |
| 4c | 6.9 | 436 |
| 4d | 6.9 | 437 |

The devices of Examples 4a to 4d showed an identical EQE of 6.9%

The devices of example 4a to 4d show comparable $LT_{85}$ in the range of 410-440 h. As the different annealing temperatures gave similar low roughness for the HTL films based on Compound B, this confirms that obtaining long lifetime is related to the low roughness of the film rather than an impact of the annealing temperature.

The data of the preceding examples show that the adjustment of surface roughness to the values set forth in claim 1 and the dependent claims significantly improves the lifetime of the devices.

**Claims**

1. Multilayered organic electronic device wherein at least one non-electrode layer thereof before deposition of the subsequent layer has a surface roughness RMS value of 3.5 nm or less as measured by atomic force microscopy with a probe tip diameter of 7 nm and a scanned surface area of 5x5 $\mu m^2$

2. Multilayered organic electronic diode in accordance with claim 1 wherein the at least one non-electrode layer has a surface roughness RMS value of 3 nm or less.

3. Multilayered organic electronic device in accordance with claim 1 or 2, wherein the at least one non-electrode layer has a surface roughness (RMS) of 2 nm or less.

4. Multilayered organic electronic device in accordance with any of claims 1 to 3 wherein the at least one non-electrode layer with the surface roughness RMS value of 3.5 nm or less is the emitting layer or the hole transport layer.

5. Multilayered organic electronic device in accordance with claim 4 wherein the hole transport layer comprises a compound of formula

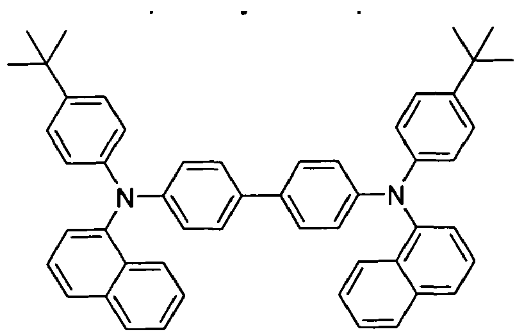

or

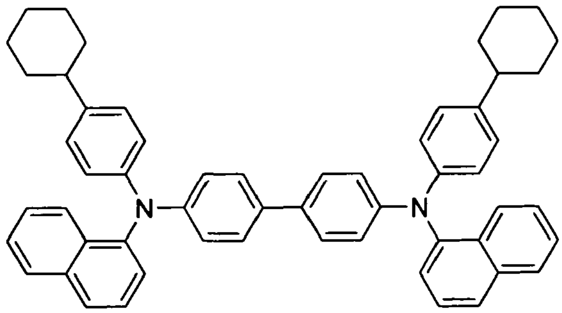

6. Multilayered organic electronic device in accordance with at least one of claims 1 to 5 wherein the device is an organic light emitting diode.

7. A process for the manufacture of multi-layered organic electronic devices comprising at least one non-electrode layer by subsequent deposition of layers wherein for at least one non-electrode layer the surface roughness RMS is determined by atomic force microscopy with a probe tip diameter of 7 nm and a scanned surface area of 5x5 $\mu m^2$ prior to the deposition of the subsequent layer, and, if the surface roughness thus determined exceeds 3.5 nm, the surface roughness of said non-electrode layer is reduced 3.5 nm or less prior to the deposition of the subsequent layer.

8. The process in accordance with claim 7 wherein the surface roughness RMS is reduced to 3nm or less.

9. The process in accordance with any of claims 7 or 8 wherein the surface roughness RMS is reduced to 2 nm or less.

10. The process in accordance with any of claims 7 to 9 wherein the surface roughness RMS is reduced by chemical etching, irradiation or thermal annealing.

11. The process in accordance with claim 10 wherein the surface roughness RMS is reduced by thermal annealing.

12. The process in accordance with claim 11 wherein the thermal annealing is carried out at a temperature of from 70 to 200 °C.

13. The process in accordance with any of claims 10 to 12 wherein the thermal annealing is carried out for a period of time of from 2 to 180 min.

Figure 1. Structure of the OLED devices used in Examples 3a to 3d.

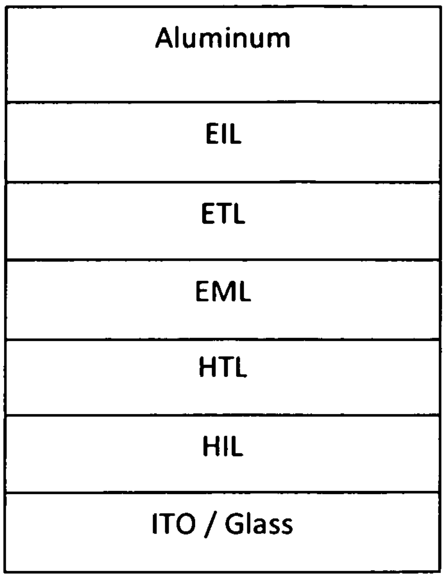

Figure 2. Lifetime data for devices of Examples 3a to 3d ($L_0$ = 2000 cd/m²)

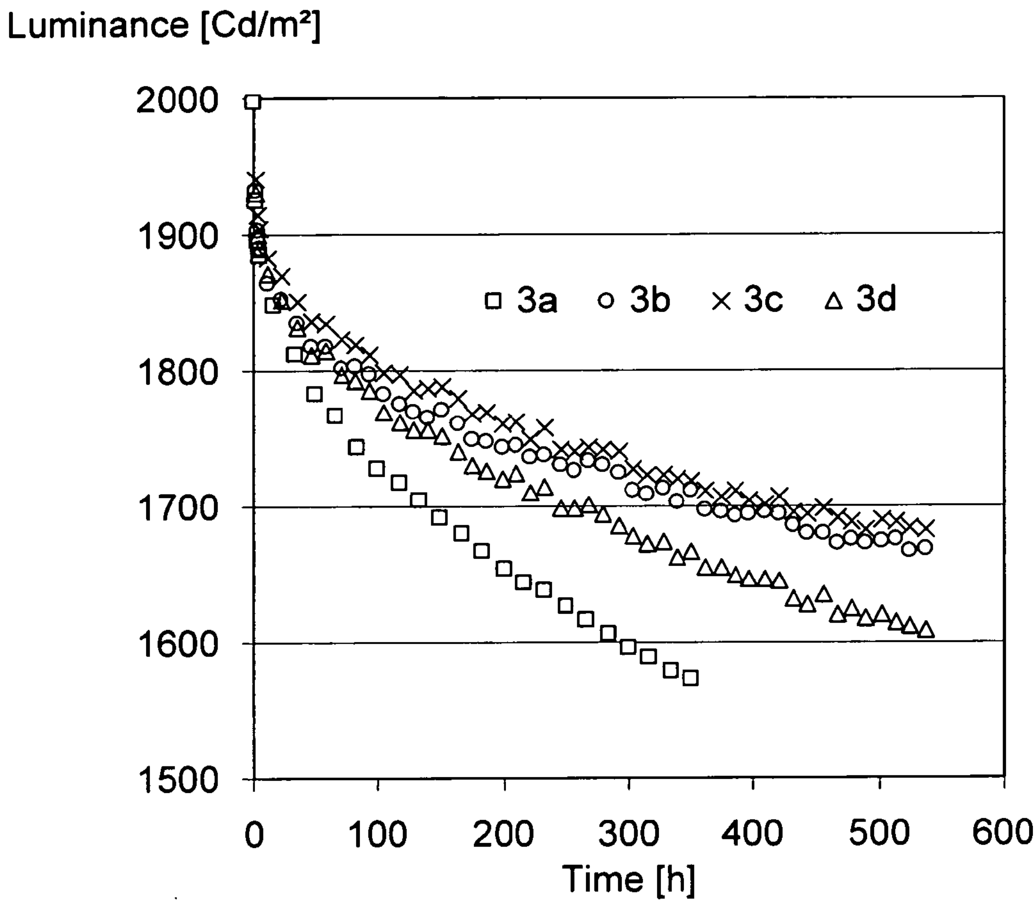

Europäisches Patentamt
European Patent Office
Office européen des brevets

# EUROPEAN SEARCH REPORT

Application Number
EP 12 00 5808

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 9 194441 A (IDEMITSU KOSAN CO) 29 July 1997 (1997-07-29) * paragraph 9 - column 8, line 1 * ----- | 1-6 | INV. H01L51/00 H01L51/50 |
| X | US 2005/184653 A1 (SUH MIN-CHUL [KR] ET AL) 25 August 2005 (2005-08-25) * example 1 * ----- | 1,4,6 | |
| X | US 2006/170337 A1 (LEE TAE-WOO [KR] ET AL) 3 August 2006 (2006-08-03) * paragraph [0135]; example measurement example 4 * ----- | 1-4,6 | |
| X | US 2009/062440 A1 (MARKS TOBIN J [US] ET AL) 5 March 2009 (2009-03-05) * paragraph [0046]; example 11; table 2 * ----- | 1-4,6 | |
| X | KWONG C Y ET AL: "Influence of the substrate temperature to the performance of tris (8-hydroxyquinoline) aluminum based organic light emitting diodes", THIN SOLID FILMS, ELSEVIER-SEQUOIA S.A. LAUSANNE, CH, vol. 458, no. 1-2, 30 June 2004 (2004-06-30), pages 281-286, XP004510367, ISSN: 0040-6090, DOI: 10.1016/J.TSF.2004.01.042 * page 283, column 1, line 35 - column 2, line 3; figure 2 * ----- | 1-4,6-13 | TECHNICAL FIELDS SEARCHED (IPC) H01L |

The present search report has been drawn up for all claims

| Place of search | Date of completion of the search | Examiner |
|---|---|---|
| The Hague | 15 January 2013 | Fratiloiu, Silvia |

6

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

**ANNEX TO THE EUROPEAN SEARCH REPORT ON EUROPEAN PATENT APPLICATION NO.** EP 12 00 5808

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2013

| Patent document cited in search report | Publication date | Patent family member(s) | Publication date |
|---|---|---|---|
| JP 9194441 A | 29-07-1997 | JP 3168897 B2 | 21-05-2001 |
| | | JP 9194441 A | 29-07-1997 |
| US 2005184653 A1 | 25-08-2005 | CN 1658721 A | 24-08-2005 |
| | | JP 2005235733 A | 02-09-2005 |
| | | KR 20050082951 A | 24-08-2005 |
| | | US 2005184653 A1 | 25-08-2005 |
| US 2006170337 A1 | 03-08-2006 | CN 101009360 A | 01-08-2007 |
| | | JP 2006216962 A | 17-08-2006 |
| | | KR 20060089097 A | 08-08-2006 |
| | | US 2006170337 A1 | 03-08-2006 |
| | | US 2011193069 A1 | 11-08-2011 |
| US 2009062440 A1 | 05-03-2009 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **LEE et al.** *Thin Solid Films,* 2002, vol. 411, 11-16
- **GRUNER et al.** *ACS nano,* 2009, vol. 3 (8), 2258-2264
- **YOKOYAMA et al.** *J. Electrochem. Soc.,* 2007, vol. 154, J159-J162